# EUROPÄISCHE PATENTSCHRIFT

(11) **EP 4 055 401 B1**
(45) Veröffentlichungstag und Bekanntmachung des Hinweises auf die Patenterteilung: **14.08.2024**
(21) Anmeldenummer: 20792309.5
(22) Anmeldetag: 05.10.2020
(51) Int. Cl.: G01R 15/18, G01R 31/54

(54) **ÜBERWACHUNGSANORDNUNG ZUR ERKENNUNG VON ZULEITUNGSFEHLERN FÜR EIN STEUERGERÄT**
MONITORING ARRANGEMENT FOR THE DETECTION OF FEED-LINE FAULTS FOR A CONTROL APPARATUS
ARRANGEMENT DE SURVEILLANCE POUR LA DÉTECTION DE DÉFAUTS DE LIGNE D'ALIMENTATION POUR UN APPAREIL DE COMMANDE

(30) Priorität: 06.11.2019 DE 102019217083
(43) Veröffentlichungstag der Anmeldung: 14.09.2022
(73) Patentinhaber: Robert Bosch GmbH, 70442 Stuttgart (DE)
(72) Erfinder: ZUSCHLAG, Rainer, 71636 Ludwigsburg (DE)
(86) Internationale Anmeldenummer: PCT/EP2020/077804
(87) Internationale Veröffentlichungsnummer: WO 2021/089257

(56) Entgegenhaltungen:
- EP-A2- 0 644 429
- DE-A1- 102010 001 335

## Beschreibung

Die Erfindung geht aus von einer Überwachungsanordnung zur Erkennung von Zuleitungsfehlern für ein Steuergerät nach der Gattung des unabhängigen Patentanspruchs 1. Gegenstand der vorliegenden Erfindung ist auch ein Verfahren zur Erkennung von Zuleitungsfehlern für ein Steuergerät.

Aus dem Stand der Technik sind Steuergeräte, wie beispielsweise Airbag-Steuergeräte, mit redundanter Masseversorgung bekannt. Diese Redundanz ermöglicht auch ein weiteres ungestörtes Funktionieren der Steuergeräte, selbst wenn eine der redundant ausgeführten Masseleitungen aufgrund eines Defektes, wie beispielsweise Kabelbruch, oxidierter Kontakt im Stecker, usw., nicht mehr zur Verfügung steht. Für die Steuergeräte selbst hat ein solche Defekt zunächst keine Auswirkung auf die Funktion, da ja noch mindestens eine weitere Masseleitung als Redundanz vorhanden ist. Im Idealfall sollte aber insbesondere in Steuergeräten mit hoher ASIL Bewertung, (ASIL: Automotive Safety Integrity Level) keine bzw. nur sehr wenige unentdeckte (schlafende) Fehler auftreten können. So gibt es Anforderungen an die maximale Impedanz der einzelnen Masseleitungen, welche verhindern soll, dass sich das Massepotential der einzelnen Steuergeräte untereinander zu stark unterscheidet. Gerade die Kommunikation zwischen den einzelnen Steuergeräten ist anfällig für eine solche auch als "Ground-Shift" bezeichnete Verschiebung des Massepotentials. Zudem gibt es EMV/ESD Anforderungen, die nur erfüllt werden können, wenn die Steuergeräte sehr gut an Masse angebunden sind. Für die redundant ausgeführten Masseleitungen ist die Überwachung auf eine erhöhte, eventuell bis zur Unterbrechung erhöhte Impedanz einer der Masseleitungen eine besondere Herausforderung. Die niedrige geforderte Impedanz ist ja durch die redundante Masseleitung nach wie vor gegeben. Aus diesem Grund schlägt hier eine normale Widerstandsmessung zwischen dem Massepotential der Fahrzeugspannungsversorgung, typischerweise ein Minuspol der Fahrzeugbatterie, und dem Massepotential der einzelnen Steuergeräte fehl.

Aus der DE 10 2010 001 335 A1 ist ein elektronisches Gerät mit einer gattungsgemäßen Überwachungsanordnung zur Erkennung von Zuleitungsfehlern bekannt, welche mindestens eine redundant außerhalb des Geräts liegende stromführende Versorgungsleitung umfasst, welche das Gerät zumindest anteilig oder ganz mit Energie versorgt, wobei die außerhalb liegende redundante Versorgungsleitung jeweils mit innerhalb des Geräts angeordneten Innenleitern, wie beispielsweise Leiterbahnen, elektrisch verbunden ist. Die Innenleiter verlaufen in einem Bereich benachbart zueinander, wobei benachbart zu den Innenleitern, insbesondere zwischen den Innenleitern, mindestens eine Magnetfelddetektoreinheit angeordnet ist, mit welcher ein statisches und/oder ein zeitabhängiges Magnetfeld messbar ist. In der Überwachungsanordnung ist eine Zuleitungsfehlererkennungsschaltung vorhanden, welche aus dem mit der Magnetfelddetektoreinheit gewonnenen Signal ein Fehlersignal gewinnt, mit welchem ein Fehler in der Versorgungsleitung feststellbar ist. Im einfachsten Fall ist die Magnetfelddetektoreinheit bevorzugt eine Magnetspule, welche insbesondere zur Erhöhung der Signalstärke einen Spulenkern aus einem Material mit hoher Permeabilität aufweist. Der Spulenkern ist beispielsweise aus einem ferromagnetischen Werkstoff hergestellt. Die Windungszahl der Magnetspule ist so hoch ausgelegt, dass im Verhältnis zum verfügbaren Bauraum eine möglichst hohe Messempfindlichkeit erreicht wird. Typischerweise hat die Magnetspule einen Wickelkern, der so aufgebaut ist, dass eine kompakte Montage auf einer Leiterplatte möglich ist. So kann beispielsweise die Spule einen garnrollenartigen Wickelkern aufweisen, der einen lediglich kurz bemessenen Zylinderabschnitt hat.

### Offenbarung der Erfindung

Die erfindungsgemäße Überwachungsanordnung zur Erkennung von Zuleitungsfehlern für ein Steuergerät mit den Merkmalen des unabhängigen Patentanspruchs 1 und das erfindungsgemäße Verfahren zur Erkennung von Zuleitungsfehlern für ein Steuergerät mit den Merkmalen des unabhängigen Patentanspruchs 7 080 haben jeweils den Vorteil, dass die Enddeckung einer erhöhten Impedanz in einer der redundant ausgeführten Versorgungsleitungen durch Analyse und Auswertung der Stromaufteilung in den jeweiligen Versorgungsleitungen möglich ist. Hierzu wird ein hochfrequenter Anteil des Rückstromes des Steuergeräts auf den redundanten Versorgungsleitungen induktiv auf eine Auswerte- und Steuereinheit übertragen. Zur Verbesserung der Signalqualität kann der Auswerte- und Steuerschaltung eine Signalaufbereitung vorgeschaltet werden. Das Steuergerät wird aus einer Gleichspannungsquelle, typischerweise aus einer Batterie mit Strom versorgt. Bei Hybridfahrzeugen oder vollelektrischen Fahrzeugen ist auch der Einsatz eines Gleichstromkonverternetzteils zur Bereitstellung der nötigen Gleichspannung denkbar. Dieser Strom fließt von einem positiven Pol durch die Schaltung des Steuergeräts zurück zum negativen Pol der Gleichspannungsquelle. Aufgrund von verschiedenen Schaltvorgängen im Steuergerät ist der Stromfluss im Steuergerät ECU aus dem positiven Pol heraus nicht konstant. Diese Schaltvorgänge im Steuergerät können von Gleichstromkonvertern im Steuergerät sowie von Schaltvorgängen einer Rechnereinheit, Sensoren, Aktuatoren usw. als auch durch eine interne Kommunikation im Steuergerät über Kommunikationsbusse (SPI, Adress- und Daten-Busse der Speicher usw.), als auch durch eine externe Kommunikation mit anderen Steuergeräten über Fahrzeugbussysteme, wie beispielsweise CAN, FlexRay, Ethernet usw. hervorgerufen werden. Diese hochfrequente dynamische durch interne Schaltvorgänge hervorgerufene Stromaufnahme des Steuergeräts wird bei Steuergeräten mit redundanten Versorgungsleitungen zur Erkennung von Zuleitungsfehlern herangezogen, um die defekte Versorgungsleitung mit signifikant höherer Impedanz herauszufinden.

Ausführungsformen der vorliegenden Erfindung stellen eine Überwachungsanordnung zur Erkennung von Zuleitungsfehlern für ein Steuergerät, mit mindestens zwei zueinander redundanten stromführenden innerhalb des Steuergeräts angeordneten internen Versorgungsleitungen, welche an einem Ende jeweils mit einer externen Versorgungsleitung und am anderen Ende jeweils mit einer gemeinsamen internen Versorgungspotentiallage des Steuergeräts elektrisch verbunden sind, einer Signalerfassung, welche induktiv einen Stromfluss durch die einzelnen internen Versorgungsleitungen erfasst und mindestens ein korrespondierendes Messsignal ausgibt, und einer Auswerte- und Steuereinheit zur Verfügung, welche das mindestens eine Messsignal zur Zuleitungsfehlererkennung auswertet. Hierbei bilden die beiden internen Versorgungsleitungen vor der elektrischen Verbindungsstelle mit der gemeinsamen internen Versorgungspotentiallage jeweils eine planare Versorgungsleitungsspule mit mindestens einer Windung aus, wobei die Signalerfassung für jede der Versorgungsleitungsspulen mindestens eine planare Sensorspule aufweist, welche jeweils einer der Versorgungsleitungsspulen zugeordnet ist und einen durch interne Schaltvorgänge verursachten hochfrequenten dynamischen Stromfluss durch die korrespondierende Versorgungsleitungsspule erfasst.

Zudem wird ein Verfahren zur Erkennung von Zuleitungsfehlern für ein Steuergerät vorgeschlagen, welches mit einer solchen Überwachungsanordnung ausgeführt werden kann. Hierbei wird innerhalb des Steuergeräts jeweils ein Stromfluss in mindesten zwei zueinander redundanten stromführenden internen Versorgungsleitungen, welche an einem Ende jeweils mit einer externen Versorgungsleitung und am anderen Ende mit einer gemeinsamen Versorgungpotentiallage verbunden sind, induktiv erfasst, wobei die erfassten Stromsignale miteinander verglichen und ausgewertet werden. Hierbei wird als Stromfluss ein durch interne Schaltvorgänge verursachter hochfrequenter dynamischer Strom durch die mindestens zwei internen Versorgungsleitungen in mindesten zwei planaren Versorgungsleitungsspulen, welche die internen Versorgungsleitungen jeweils vor der elektrischen Verbindungsstelle mit gemeinsamen internen Versorgungspotentiallage ausbilden, jeweils von mindestens einer planare Sensorspule erfasst, welche der korrespondierenden planaren Versorgungsleitungsspule zugeordnet ist.

Im Normalfall, in welchem gleich gute Versorgungsverbindungen in den redundanten mindestens zwei Versorgungsleitungen vorliegen, teilt sich ein Versorgungsstrom des Steuergeräts gleichmäßig auf die vorhandenen redundanten Versorgungsleitungen auf. Die Auswerte- und Steuereinheit wertet die Differenz zwischen den redundanten Versorgungsleitungen aus. Bei einer annähernden Gleichverteilung der Ströme in den redundanten Versorgungsleitungen ist die Differenz sehr klein, bzw. geht gegen null. Für den Fall, dass sich die Impedanz auf einer der redundanten Versorgungsleitungen signifikant erhöht hat, beispielsweise aufgrund eines Kabelbruchs, eines oxidierten Kontakts im Stecker usw., teilt sich der Strom nun asymmetrisch auf die redundanten Versorgungsleitungen auf, bzw. fliest nur noch über die verbleibende(n) Versorgungsleitung(en). Die Auswerte- und Steuereinheit stellt nun eine signifikante Differenz zwischen den redundanten Versorgungsleitungen fest, und kann das aufbereitete und gefilterte Signal analog oder bereits digital einem Mikrocontroller oder Mikroprozessor oder einer Recheneinheit zur weiteren Verarbeitung zur Verfügung stellen. Zudem kann die Auswerte- und Steuereinheit selbst als Teil des Mikrocontrollers oder Mikroprozessors oder der Recheneinheit ausgeführt werden. Eine entsprechende Applikation bzw. Funktion auf der Recheneinheit kann dann weitere Schritte zur Fahrerinformation vornehmen, bzw. einen Fehler im Fehlerspeicher ablegen.

Unter der Auswerte- und Steuereinheit kann vorliegend eine elektrische Schaltung verstanden werden, welche erfasste Sensorsignale verarbeitet bzw. auswertet. Die Auswerte- und Steuereinheit kann mindestens eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Auswerte- und Steuereinheit beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind. Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert ist und zur Durchführung der Auswertung verwendet wird, wenn das Programm von der Auswerte- und Steuereinheit ausgeführt wird.

Unter einer Versorgungsleitung wird vorliegend eine Masseleitung oder eine Spannungsversorgungsleitung verstanden, welche dem Steuergerät ein entsprechendes Spannungspotential zur Verfügung stellt. So kann beispielsweise eine redundante Masseversorgung des Steuergeräts über mindestens zwei redundante Masseleitungen umgesetzt werden. Im Steuergerät können die korrespondierenden redundanten internen Masseleitungen an einer gemeinsamen Massepotentiallage zusammengeführt werden. Entsprechend kann eine redundante Spannungsversorgung über mindestens zwei redundante Spannungsversorgungsleitungen realisiert werden. Im Steuergerät können die korrespondierenden redundanten internen Spannungsversorgungsleitungen an einer gemeinsamen Spannungspotentiallage zusammengeführt werden.

Durch die in den abhängigen Ansprüchen aufgeführten Maßnahmen und Weiterbildungen sind vorteilhafte Verbesserungen der im unabhängigen Patentanspruch 1 angegebenen Überwachungsanordnung zur Erkennung von Zuleitungsfehlern für ein Steuergerät und des im unabhängigen Patentanspruch 7 angegebenen Verfahrens zur Erkennung von Zuleitungsfehlern für ein Steuergerät möglich.

Besonders vorteilhaft ist, dass die mindestens zwei planaren Versorgungsleitungsspulen identisch ausgeführt werden können. Zudem können die mindestens zwei planaren Sensorspulen identisch mit einer größeren Windungszahl als die mindestens zwei Versorgungsleitungsspulen ausgeführt werden. Um den Einfluss auf die gemeinsame Spannungspotentiallage im Steuergerät und auf die Versorgungsleitungen im Fahrzeug minimal zu halten, wird der hochfrequente dynamische durch interne Schaltvorgänge hervorgerufene Stromfluss, der sich aus allen Schaltungsteilen auf der gemeinsamen Versorgungspotentiallage gesammelt hat, nun durch identische planare Versorgungsleiterspulen zu den redundanten internen Versorgungsleitungen geleitet. Die planaren Versorgungsleiterspulen weisen relativ wenige "Windungen" mit breiten Leiterbahnen auf, um Stromanforderungen des Steuergeräts zu entsprechen. Der hochfrequente dynamische durch interne Schaltvorgänge hervorgerufene Stromfluss induziert in den planaren Versorgungsleiterspulen ein kleines elektromagnetisches Feld. Dieses elektromagnetische Feld kann nun über eine oder mehrere planare Sensorspulen aufgenommen werden und der Auswerte- und Steuereinheit zugeführt werden. Die planaren Sensorspulen umfassen im Normalfall wesentlich mehr "Windungen" mit schmaleren Leiterbahnen als die planaren Versorgungsleiterspulen, um die jeweilige planare Sensorspule empfindlicher für das kleine induzierte elektromagnetische Feld zu machen. Abhängig von dem verfügbaren Platz auf der Leiterplatte können die planare Versorgungsleiterspulen bzw. die planare Sensorspulen verschiedene Formen von kreisförmig, oval, quadratisch, rechteckig, mehreckig symmetrisch, sowie mehreckig asymmetrisch aufweisen. Bei allen eckigen Varianten können die Richtungsänderungen der Leiterbahn in abgefaster oder abgerundeter Leiterbahnführung erfolgen.

In vorteilhafter Ausgestaltung der Überwachungsanordnung können die mindestens zwei planaren Versorgungsleitungsspulen jeweils in einer ersten Leiterplattenschicht einer mehrschichtigen Leiterplatte angeordnet werden, und die zugeordnete mindestens eine planare Sensorspule kann in einer zweiten Leiterplattenschicht oberhalb oder unterhalb der ersten Leiterplattenschicht angeordnet werden. So können die mindestens zwei planaren Versorgungsleitungsspulen beispielsweise nebeneinander in der gleichen ersten Leiterplattenschicht angeordnet werden, und die den planaren Versorgungsleitungsspulen zugeordneten planaren Sensorspule können nebeneinander in einer oberhalb oder unterhalb der ersten Leiterplattenschicht angeordneten zweiten Leiterplattenschicht angeordnet werden. Das bedeutet, dass die Leiterplatte vorzugsweise als mehrschichtige bedruckte Leiterplatte (PCB) ausgeführt ist. Alternativ können die planaren Sensorspulen und die planaren Versorgungsleitungsspulen jeweils in verschiedenen Leiterplattenschichten angeordnet werden. Das bedeutet, dass beispielsweise zwei planare Versorgungsleitungsspulen und die zugeordneten zwei Sensorspulen als Stapel in vier Leiterplattenschichten angeordnet sind.

In weiterer vorteilhafter Ausgestaltung der Überwachungsanordnung kann die zugeordnete mindestens eine planare Sensorspule die korrespondierende planare Versorgungsleitungsspule zumindest bereichsweise, vorzugsweise vollständig, überdecken. Die planaren Sensorspulen liegen idealerweise deckungsgleich über bzw. zwischen den planaren Versorgungsleiterspulen in einer anderen Leiterplattenschicht, um den Kopplungsfaktor zwischen den planare Versorgungsleiterspulen und den planaren Sensorspulen zu maximieren.

In weiterer vorteilhafter Ausgestaltung der Überwachungsanordnung kann zwischen der Signalerfassung und der Auswerte- und Steuereinheit eine Signalaufbereitung eingeschleift werden, welche das erfasste mindestens eine Messsignal aufbereiten kann. Dadurch kann die Signalqualität vor der Auswertung verbessert werden. Die Signalaufbereitung kann beispielsweise einen Gleichrichter und/oder einen Filter und/oder einen Verstärker umfassen. Die in die planaren Sensorspulen induzierte Spannung kann durch die Signalaufbereitung signaltechnisch aufbereitet werden. So kann nach einer optionalen Gleichrichtung und Filterung das nach wie vor kleine Messsignal verstärkt werden. Als Verstärker bieten sich hier mehrere Stufen aus Operationsverstärkern oder ein Instrumentenverstärker mit geringem Rauschen an. Das so aufbereitete Messsignal kann nun für eine komplexere Auswertung einem Analog-Digital-Wandler zugeführt und in der Rechnereinheit weiterverarbeitet werden. Alternativ kann eine einfache Auswertung mit einer Komparatorschaltung durchgeführt werden.

In vorteilhafter Ausgestaltung des Verfahrens zur Erkennung von Zuleitungsfehlern für ein Steuergerät wird kein Zuleitungsfehler erkannt, wenn eine Stromverteilung in den mindestens zwei Versorgungsleitungsspulen innerhalb eines vorgegebenen Toleranzfensters identisch sind, und sonst wird ein Zuleitungsfehler erkannt. Zudem können durch verschiedene Toleranzfenster unterschiedliche Genauigkeitsklassen für die erkannten Zuleitungsfehler vorgegeben werden. Je nach verwendeter Topologie und Anordnung der planaren Versorgungsleiterspulen in den internen Versorgungspfaden, der Anzahl bzw. Anordnung der planare Sensorspulen, des Wicklungssinns zwischen den planare Versorgungsleiterspulen untereinander als auch zu den planaren Sensorspulen sowie der Komplexität der Auswerte- und Steuereinheit sind verschiedene Stufen und Genauigkeitsklassen der Erkennung von Zuleitungsfehlern von einfach bis komplex möglich.

Bei einer einfachen Leitungsfehlererkennung kann eine signifikant erhöhte Impedanz einer der redundanten Versorgungsleitung erkannt werden, ohne eine Aussage darüber zu machen, um welche der Versorgungsleitungen es sich handelt. Zudem kann keine Aussage über die noch verbleibenden Qualität der Versorgungsleitung gemacht werden. Bei einer komplexeren Leitungsfehlererkennung kann eine Aussage darüber gemacht werden, welche der redundanten Versorgungsleitungen eine erhöhte Impedanz aufweist. Zudem kann ein Klassifikation der redundanten Versorgungsleitungen in verschiedene Fehlerklassen vorgenommen werden. So können die redundanten Versorgungsleitungen als fehlerfrei klassifiziert werden, wenn die Impedanzunterschiede innerhalb eines engen Toleranzfensters liegen. Bei einem leicht erhöhten Impedanzunterschied, welcher in einem weiteren aber noch akzeptablen Toleranzfenster liegt, kann der Fehler intern gespeichert, aber keine Fahrerinformation ausgegeben werden. Der intern gespeicherte Fehler kann dann über eine Diagnoseschnittstelle beim nächsten Werkstattbesuch ausgelesen werden. Bei einem signifikant erhöhten Impedanzunterschied, welcher außerhalb des noch akzeptablen Toleranzfenster liegt, kann der Fehler intern gespeichert und eine entsprechende Fahrerinformation, beispielsweise über eine Warnlampe oder ein Multifunktionsdisplay ausgegeben werden. Bei einer unterbrochenen Versorgungsleitung und einem maximalen Impedanzunterschied, kann der Fehler intern gespeichert und eine entsprechende Fahrerinformation, beispielsweise über eine Warnlampe oder ein Multifunktionsdisplay ausgegeben werden. Somit kann eine auf die Kundenanforderung zugeschnittene Skalierung und Optimierung im Hinblick auf Leiterplattenfläche, Anzahl der verwendeten Komponenten der Auswerte- und Steuereinheit und somit auch der Kosten erreicht werden.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Darstellung eines Steuergeräts mit einem Ausführungsbeispiel einer erfindungsgemäßen Überwachungsanordnung zur Erkennung von Zuleitungsfehlern für ein Steuergerät.
Fig. 2 zeigt eine schematische Draufsicht auf ein erstes Ausführungsbeispiel einer Signalerfassung für die erfindungsgemäße Überwachungsanordnung aus Fig. 1 ohne Darstellung einer mehrschichtigen Leiterplatte, in welcher die Signalerfassung angeordnet ist.
Fig. 3 zeigt eine schematische perspektivische Darstellung von planaren Versorgungsleiterspulen und planaren Sensorspulen für die Signalerfassung aus Fig. 2 und eine schematische Schnittdarstellung einer korrespondierenden mehrschichtigen Leiterplatte, in welcher die Signalerfassung angeordnet ist.
Fig. 4 zeigt eine schematische perspektivische Darstellung von planaren Versorgungsleiterspulen und planaren Sensorspulen für ein zweites Ausführungsbeispiel einer Signalerfassung und eine schematische Schnittdarstellung einer korrespondierenden mehrschichtigen Leiterplatte, in welcher die Signalerfassung angeordnet ist.
Fig. 5 zeigt ein schematisches Ablaufdiagramm eines Ausführungsbeispiels eines erfindungsgemäßen Verfahrens zur Erkennung von Zuleitungsfehlern für ein Steuergerät.

### Ausführungsformen der Erfindung

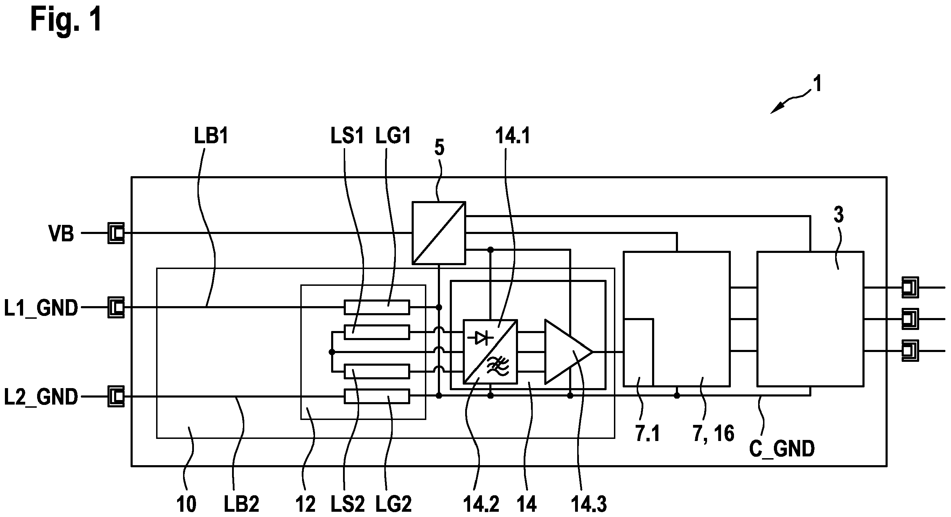

Wie aus Fig. 1 bis 4 ersichtlich ist, umfassen die dargestellten Ausführungsbeispiele einer erfindungsgemäßen Überwachungsanordnung 10 zur Erkennung von Zuleitungsfehlern für ein Steuergerät 1, jeweils mindestens zwei zueinander redundante stromführende innerhalb des Steuergeräts 1 angeordnete interne Versorgungsleitungen LB1, LB2, welche an einem Ende jeweils mit einer externen Versorgungsleitung L1_GND, L2_GND und am anderen Ende jeweils mit einer gemeinsamen internen Versorgungspotentiallage C_GND des Steuergeräts 1 elektrisch verbunden sind, eine Signalerfassung 12, welche induktiv einen Stromfluss durch die internen Versorgungsleitungen LB1, LB2 erfasst und mindestens ein korrespondierendes Messsignal ausgibt, und eine Auswerte- und Steuereinheit 16, welche das mindestens eine Messsignal zur Zuleitungsfehlererkennung auswertet. Hierbei bilden die beiden internen Versorgungsleitungen LB1, LB2 vor der elektrischen Verbindungsstelle mit der gemeinsamen internen Versorgungspotentiallage C_GND des Steuergeräts 1 jeweils eine planare Versorgungsleitungsspule LG1, LG2 mit mindestens einer Windung aus. Die Signalerfassung 12 weist für jede der planaren Versorgungsleitungsspulen LG1, LG2 mindestens eine planare Sensorspule LS1, LS2 auf, welche jeweils einer der Versorgungsleitungsspulen LG1, LG2 zugeordnet ist und einen durch interne Schaltvorgänge verursachten hochfrequenten dynamischen Stromfluss durch die korrespondierende Versorgungsleitungsspule LG1, LG2 erfasst.

Wie aus Fig. 1 weiter ersichtlich ist, umfasst das Steuergerät 1 im dargestellten Ausführungsbeispiel eine redundante Masseversorgung mit zwei zueinander redundanten stromführenden innerhalb des Steuergeräts 1 angeordnete internen Versorgungsleitungen LB1, LB2, welche an einem Ende jeweils mit einer externen Versorgungsleitung L1_GND, L2_GND verbunden sind. Zudem versorgt eine weitere nicht näher bezeichnete Versorgungsleitung das Steuergerät 1 mit einer Bordnetzspannung VB des korrespondierenden Fahrzeugs. Zudem umfasst das Steuergerät 1 im dargestellten Ausführungsbeispiel einen Gleichspannungswandler 5, welcher aus der Bordnetzspannung VB verschiedene interne Spannungen für eine Recheneinheit 7 und eine Kommunikationseinheit 3 des Steuergeräts 1 erzeugt. Im dargestellten Ausführungsbeispiel weist die Recheneinheit 7 einen Analog-Digital-Wandler 7.1 auf, welcher ein analoges Messsignal der Überwachungsschaltung 10 in ein digitales Signal umwandelt. Zudem übernimmt die Recheneinheit 7 die Funktion der Auswerte- und Steuereinheit 16 der Überwachungsanordnung 10 und wertet das Messsignal zur Erkennung eines Zuleitungsfehlers aus. Wie aus Fig. 1 weiter ersichtlich ist, umfasst die dargestellte Überwachungsanordnung 10 eine Signalaufbereitung 14, welche zwischen der Signalerfassung 12 und der Auswerte- und Steuereinheit 16 eingeschleift ist und das erfasste mindestens eine Messsignal aufbereitet. Hierzu umfasst die Signalaufbereitung 14 im dargestellten Ausführungsbeispiel einen Gleichrichter 14.1, einen Filter 14.2 und einen Verstärker 14.3. Die Signalaufbereitung 14 empfängt die beiden erfassten Stromsignale bildet ein Differenzsignal als Messsignal, welches durch die nachfolgende Auswerte- und Steuereinheit 16 weiter ausgewertet und klassifiziert wird.

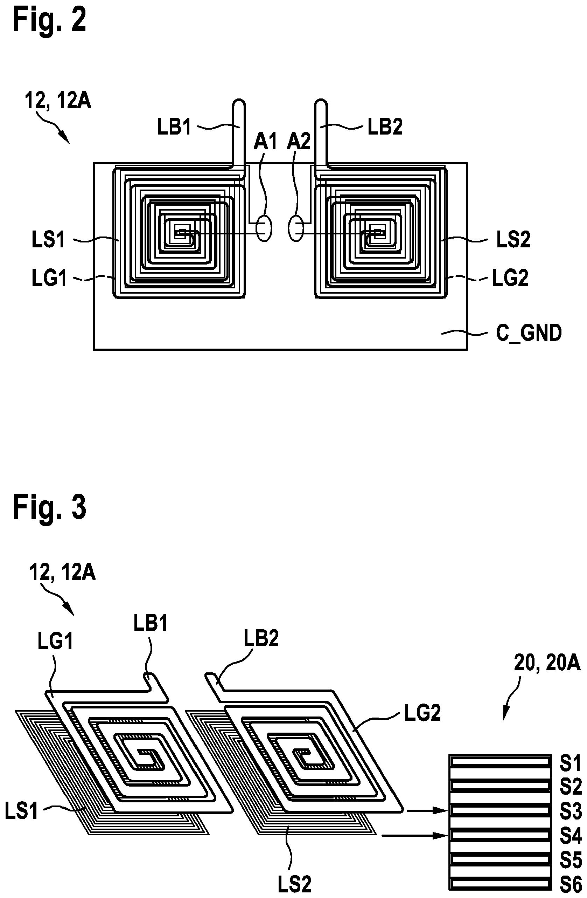

Wie insbesondere aus Fig. 2 bis 4 ersichtlich ist, sind die mindestens zwei planaren Versorgungsleitungsspulen LG1, LG2 identisch ausgeführt. Auch die mindestens zwei planaren Sensorspulen LS1, LS2 sind identisch, jedoch mit einer größeren Windungszahl als die mindestens zwei Versorgungsleitungsspulen LG1, LG2 ausgeführt.

Im dargestellten Ausführungsbeispiel umfasst die Überwachungsanordnung 10 zwei interne Versorgungsleitungen LB1, LB2, welche jeweils eine planare Versorgungsleitungsspule LG1, LG2 ausbilden. Hierbei ist den planaren Versorgungsleitungsspulen LG1, LG2 jeweils eine planare Sensorspule LS1, LS2 zugeordnet.

Wie aus Fig. 2 und 3 weiter ersichtlich ist, sind die beiden planaren Versorgungsleitungsspulen LG1, LG2 im dargestellten ersten Ausführungsbeispiel der Signalerfassung 12A jeweils in einer dritten Leiterplattenschicht S3 einer mehrschichtigen Leiterplatte 20 angeordnet, welche im dargestellten Ausführungsbeispiel als mehrschichtige bedruckte Leiterplatte 20A mit sechs Leiterplattenschichten S1 bis S6 ausgeführt ist. Die beiden den Versorgungsleitungsspulen LG1, LG2 zugeordneten planaren Sensorspulen LS1, LS2 sind jeweils in einer vierten Leiterplattenschicht S4 unterhalb der dritten Leiterplattenschicht S3 angeordnet. Im dargestellten Ausführungsbeispiel werden in einer ersten und sechsten Leiterplattenschicht S1, S6 andere Signale in entsprechenden Leiterbahnen geführt. Auch in der dritten und vierten Leiterplattenschicht S3, S4 werden noch andere Signale als die Spulensignale in entsprechenden Leiterbahnen geführt. In einer zweiten Leiterplattenschicht S2 ist die gemeinsame Spannungspotentiallage C_GND, hier eine gemeinsame Massenlage des Steuergeräts 1 angeordnet. Die planare Versorgungsleiterspulen LG1, LG2 sind über nicht näher dargestellte Durchkontaktierungen mit der gemeinsamen Spannungspotentiallage C_GND in der zweiten Leiterplattenschicht S2 elektrisch verbunden. In einer fünften Leiterplattenschicht S5 ist ein gemeinsamer Rückleitungspfad der beiden planaren Sensorspulen LS1, LS2 angeordnet und mit der Signalaufbereitung 14 verbunden. Die entsprechenden Enden der planaren Sensorspulen LS1, LS2 sind über entsprechende Durchkontaktierungen oder über eine gemeinsame Durchkontaktierung elektrisch mit dem Rückleitungspfad in der fünften Leiterplattenschicht S5 verbunden. Die anderen Enden der planaren Sensorspulen LS1, LS2 sind jeweils über entsprechenden Leiterbahnen mit der Signalaufbereitung 14 elektrisch verbunden. Zudem können auch andere Signale über entsprechende Leiterbahnen in dieser Leiterplattenschicht S5 geführt werden. Wie aus Fig. 2 und 3 weiter ersichtlich ist, sind die planaren Sensorspule LS1, LS2 so angeordnet, dass sie jeweils die korrespondierende planare Versorgungsleitungsspule LG1, LG2 vollständig überdecken.

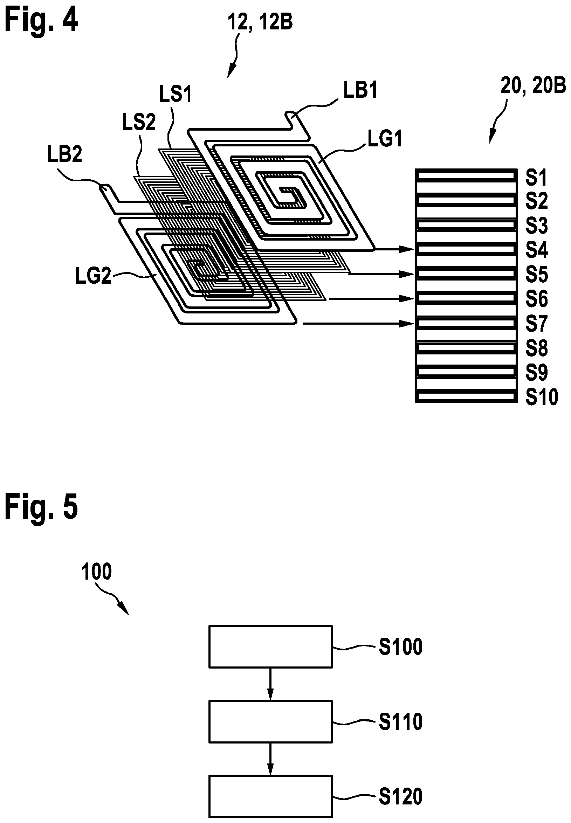

Wie aus Fig 4 weiter ersichtlich ist, sind die planaren Sensorspulen LS1, LS2 und die planaren Versorgungsleitungsspulen LG1, LG2 im dargestellten zweiten Ausführungsbeispiel der Signalerfassung 12B jeweils in verschiedenen Leiterplattenschichten S4, S5, S6, S7 einer mehrschichtigen Leiterplatte 20B angeordnet, welche im dargestellten Ausführungsbeispiel als mehrschichtige bedruckte Leiterplatte 20B mit zehn Leiterplattenschichten S1 bis S10 ausgeführt ist. Selbstverständlich können auch andere Ausführungsformen von mehrschichtigen Leiterplatten 20 verwendet werden, welche mehr oder weniger als sechs bzw. zehn Leiterplattenschichten aufweisen.

Wie aus Fig. 4 weiter ersichtlich ist, ist eine erste planare Versorgungsleitungsspule LG1 im dargestellten zweiten Ausführungsbeispiel der Signalerfassung 12B in einer vierten Leiterplattenschicht S4 angeordnet. Hierbei ist eine der ersten Versorgungsleitungsspule LG1 zugeordneten erste planare Sensorspulen LS1 in einer fünften Leiterplattenschicht S5 unterhalb der ersten Versorgungsleiterspule LG1 in der vierten Leiterplattenschicht S4 angeordnet. Eine zweite planare Versorgungsleitungsspule LG2 ist im dargestellten zweiten Ausführungsbeispiel der Signalerfassung 12B in einer siebten Leiterplattenschicht S7 angeordnet. Hierbei ist eine der zweiten Versorgungsleitungsspule LG2 zugeordneten zweite planare Sensorspulen LS2 in einer sechsten Leiterplattenschicht S6 oberhalb der zweiten planaren Versorgungsleiterspule LG2 in der siebten Leiterplattenschicht S7 angeordnet. Somit sind die beiden planare Sensorspulen LS1, LS2 im dargestellten zweiten Ausführungsbeispiel der Signalerfassung 12B zwischen den beiden planaren Versorgungsleiterspulen LG1, LG2 angeordnet. Im dargestellten Ausführungsbeispiel werden in einer ersten, zweiten, neunten und zehnten Leiterplattenschicht S1, S2, S9, S10 andere Signale in entsprechenden Leiterbahnen geführt. Auch in der vierten bis siebten Leiterplattenschicht S4 bis S7 werden noch andere Signale als die Spulensignale in entsprechenden Leiterbahnen geführt. In einer dritten Leiterplattenschicht S3 ist die gemeinsame Spannungspotentiallage C_GND, hier eine gemeinsame Massenlage des Steuergeräts 1 angeordnet. Die planare Versorgungsleiterspulen LG1, LG2 sind über nicht näher dargestellte Durchkontaktierungen mit der gemeinsamen Spannungspotentiallage C_GND in der dritten Leiterplattenschicht S3 elektrisch verbunden. In einer achten Leiterplattenschicht S8 ist ein gemeinsamer Rückleitungspfad der beiden planaren Sensorspulen LS1, LS2 angeordnet und mit der Signalaufbereitung 14 verbunden. Die entsprechenden Enden der planaren Sensorspulen LS1, LS2 sind über entsprechende Durchkontaktierungen elektrisch mit dem Rückleitungspfad in der achten Leiterplattenschicht S8 verbunden. Die anderen Enden der planaren Sensorspulen LS1, LS2 sind jeweils über entsprechenden Leiterbahnen mit der Signalaufbereitung 14 elektrisch verbunden. Zudem können auch andere Signale über entsprechende Leiterbahnen in dieser Leiterplattenschicht S8 geführt werden. Wie aus Fig. 4 weiter ersichtlich ist, sind die planaren Sensorspule LS1, LS2 so angeordnet, dass sie jeweils die korrespondierende planare Versorgungsleitungsspule LG1, LG2 vollständig überdecken.

Wie aus Fig. 5 weiter ersichtlich ist, erfasst das dargestellte Ausführungsbeispiel des erfindungsgemäßen Verfahrens 100 zur Erkennung von Zuleitungsfehlern für ein Steuergerät 1 in einem Schritt S100 innerhalb des Steuergeräts 1 jeweils einen Stromfluss in mindesten zwei zueinander redundanten stromführenden internen Versorgungsleitungen LB1, LB2 induktiv, welche an einem Ende jeweils mit einer externen Versorgungsleitung L1_GND, L2_GND und am anderen Ende mit einer gemeinsamen Versorgungpotentiallage C_GND verbunden sind. Hierbei wird als Stromfluss ein durch interne Schaltvorgänge verursachter hochfrequenter dynamischer Strom durch die mindestens zwei internen Versorgungsleitungen LB1, LB2 in mindesten zwei planaren Versorgungsleitungsspulen LG1, LG2, welche die internen Versorgungsleitungen LB1, LB2 jeweils vor der elektrischen Verbindungsstelle mit gemeinsamen internen Versorgungspotentiallage C_GND ausbilden, jeweils von mindestens einer planare Sensorspule LS1, LS2 erfasst, welche der korrespondierenden planaren Versorgungsleitungsspule LG1, LG2 zugeordnet ist. Im Schritt S110 werden die erfassten Stromsignale miteinander verglichen und ausgewertet. Hierzu wird ein Differenzsignal aus den erfassten Stromsignalen gebildet und als Messsignal ausgewertet. So wird beispielsweise kein Zuleitungsfehler erkannt, wenn eine Stromverteilung in den mindestens zwei Versorgungsleitungsspulen LG1, LG2 identisch bzw. eine ermittelte Stromdifferenz innerhalb eines vorgegebenen Toleranzfensters liegt. Sonst wird ein Zuleitungsfehler erkannt. Im dargestellten Ausführungsbeispiel wird im Schritt S120 eine optionale Klassifizierung des erkannten Zuleitungsfehlers durchgeführt. So werden durch verschiedene Toleranzfenster unterschiedliche Genauigkeitsklassen für die erkannten Zuleitungsfehler vorgegeben. Je nach verwendeter Topologie und Anordnung der planaren Versorgungsleiterspulen LG1, LG2 in den internen Versorgungspfaden, der Anzahl bzw. Anordnung der planare Sensorspulen LS1, LS2, des Wicklungssinns zwischen den planare Versorgungsleiterspulen LG1, LG2 untereinander als auch zu den planaren Sensorspulen LS1, LS2 sowie der Komplexität der Auswerte- und Steuereinheit 16 sind verschiedene Stufen und Genauigkeitsklassen der Erkennung von Zuleitungsfehlern von einfach bis komplex möglich.

## Patentansprüche

1. Überwachungsanordnung (10) zur Erkennung von Zuleitungsfehlern für ein Steuergerät (1), wobei die Überwachungsanordnung
• mindestens zwei zueinander redundante stromführende innerhalb des Steuergeräts (1) angeordnete interne Versorgungsleitungen (LB1, LB2), welche an einem Ende jeweils mit einer externen Versorgungsleitung (L1_GND, L2_GND) und am anderen Ende jeweils mit einer gemeinsamen internen Versorgungspotentiallage (C_GND) des Steuergeräts (1) elektrisch verbunden sind,
• eine Signalerfassung (12), welche induktiv einen Stromfluss durch die einzelnen internen Versorgungsleitungen (LB1, LB2) erfasst und mindestens ein korrespondierendes Messsignal ausgibt, und
• eine Auswerte- und Steuereinheit (16), welche das mindestens eine Messsignal in Form eines Differenzsignals der Stromsignale zur Zuleitungsfehlererkennung auswertet,
aufweist,
wobei die beiden internen Versorgungsleitungen (LB1, LB2) vor der elektrischen Verbindungsstelle mit der gemeinsamen internen Versorgungspotentiallage (C_GND) des Steuergeräts (1) jeweils eine planare Versorgungsleitungsspule (LG1, LG2) mit mindestens einer Windung ausbilden,
wobei die Signalerfassung (12) für jede der planaren Versorgungsleitungsspulen (LG1, LG2) mindestens eine planare Sensorspule (LS1, LS2) aufweist, welche jeweils einer der Versorgungsleitungsspulen (LG1, LG2) zugeordnet ist und einen durch interne Schaltvorgänge verursachten hochfrequenten dynamischen Stromfluss durch die korrespondierende Versorgungsleitungsspule (LG1, LG2) erfasst.

2. Überwachungsanordnung (10) nach Anspruch 1, **dadurch gekennzeichnet, dass** die mindestens zwei planaren Versorgungsleitungsspulen (LG1, LG2) identisch ausgeführt sind, wobei die mindestens zwei planaren Sensorspulen (LS1, LS2) identisch mit einer größeren Windungszahl als die mindestens zwei Versorgungsleitungsspulen (LG1, LG2) ausgeführt sind.

3. Überwachungsanordnung (10) nach Anspruch 1 oder 2, **dadurch gekennzeichnet, dass** die mindestens zwei planaren Versorgungsleitungsspulen (LG1, LG2) jeweils in einer ersten Leiterplattenschicht (S1 bis S10) einer mehrschichtigen Leiterplatte (20) angeordnet sind, und die jeweils zugeordnete mindestens eine planare Sensorspule (LS1, LS2) in einer zweiten Leiterplattenschicht (S1 bis S10) oberhalb oder unterhalb der ersten Leiterplattenschicht (S1 bis S10) angeordnet ist;
oder
dass die planaren Sensorspulen (LS1, LS2) und die planaren Versorgungsleitungsspulen (LG1, LG2) jeweils in verschiedenen Leiterplattenschichten (S1 bis S10) angeordnet sind.

4. Überwachungsanordnung (10) nach Anspruch 1 oder 3, **dadurch gekennzeichnet, dass** die zugeordnete mindestens eine planare Sensorspule (LS1, LS2) die korrespondierende planare Versorgungsleitungsspule (LG1, LG2) zumindest bereichsweise, vorzugsweise vollständig, überdeckt.

5. Überwachungsanordnung (10) nach einem der Ansprüche 1 bis 4, **dadurch gekennzeichnet, dass** zwischen der Signalerfassung (12) und der Auswerte- und Steuereinheit (16) eine Signalaufbereitung (14) eingeschleift ist, welche das erfasste mindestens eine Messsignal aufbereitet.

6. Überwachungsanordnung (10) nach Anspruch 5, **dadurch gekennzeichnet, dass** die Signalaufbereitung (14) einen Gleichrichter (14.1) und/oder einen Filter (14.2) und/oder einen Verstärker (14.3) umfasst.

7. Verfahren (100) zur Erkennung von Zuleitungsfehlern für ein Steuergerät (1), insbesondere ein Verfahren, welches in einer Überwachungsanordnung nach einem der Ansprüche 1 bis 6 abläuft, wobei innerhalb des Steuergeräts (1) jeweils ein Stromfluss in mindestens zwei zueinander redundanten stromführenden internen Versorgungsleitungen (LB1, LB2), welche an einem Ende jeweils mit einer externen Versorgungsleitung (L1_GND, L2_GND) und am anderen Ende mit einer gemeinsamen Versorgungpotentiallage (C_GND) verbunden sind, induktiv erfasst wird, wobei die erfassten Stromsignale miteinander verglichen und ausgewertet werden, wobei als Stromfluss ein durch interne Schaltvorgänge verursachter hochfrequenter dynamischer Strom durch die mindestens zwei internen Versorgungsleitungen (LB1, LB2) in mindestens zwei planaren Versorgungsleitungsspulen (LG1, LG2), welche die internen Versorgungsleitungen (LB1, LB2) jeweils vor der elektrischen Verbindungsstelle mit der gemeinsamen internen Versorgungspotentiallage (C_GND) ausbilden, jeweils von mindestens einer planaren Sensorspule (LS1, LS2) erfasst wird, welche der korrespondierenden planaren Versorgungsleitungsspule (LG1, LG2) zugeordnet ist.

8. Verfahren (100) nach Anspruch 7, **dadurch gekennzeichnet, dass** zum Vergleich und zur Auswertung der Stromsignale aus den beiden erfassten Stromsignalen ein Differenzsignal als Messignal gebildet wird.

9. Verfahren (100) nach Anspruch 8 oder 7, **dadurch gekennzeichnet, dass** kein Zuleitungsfehler erkannt wird, wenn eine Stromverteilung in den mindestens zwei Versorgungsleitungsspulen (LG1, LG2) innerhalb eines vorgegebenen Toleranzfensters identisch ist, und sonst ein Zuleitungsfehler erkannt wird.

10. Verfahren (100) nach Anspruch 9 oder 8, **dadurch gekennzeichnet, dass** durch verschiedene Toleranzfenster unterschiedliche Genauigkeitsklassen für die erkannten Zuleitungsfehler vorgegeben werden.

## Claims

1. Monitoring arrangement (10) for detecting feed line faults for a control device (1), wherein the monitoring arrangement has
• at least two conducting internal supply lines (LB1, LB2) arranged within the control device (1) which are redundant in relation to one another and which are each electrically connected at one end to an external supply line (L1_GND, L2_GND) and at the other end to a common internal supply potential level (C_GND) of the control device (1),
• a signal detection means (12) which inductively detects a current flow through the individual internal supply lines (LB1, LB2) and outputs at least one corresponding measurement signal, and
• an evaluation and control unit (16) which evaluates the at least one measurement signal in the form of a difference signal of the current signals in order to detect feed line faults,
wherein the two internal supply lines (LB1, LB2) each form a planar supply line coil (LG1, LG2) having at least one winding upstream of the electrical connection point to the common internal supply potential level (C_GND) of the control device (1),
wherein the signal detection means (12), for each of the planar supply line coils (LG1, LG2), has at least one planar sensor coil (LS1, LS2) which is assigned to one of the supply line coils (LG1, LG2) in each case and detects a high-frequency dynamic current flow through the corresponding supply line coil (LG1, LG2) caused by internal switching operations.

2. Monitoring arrangement (10) according to Claim 1, **characterized in that** the at least two planar supply line coils (LG1, LG2) have an identical design, wherein the at least two planar sensor coils (LS1, LS2) have an identical design and have a greater number of windings than the at least two supply line coils (LG1, LG2).

3. Monitoring arrangement (10) according to Claim 1 or 2, **characterized in that** the at least two planar supply line coils (LG1, LG2) are each arranged in a first circuit board layer (S1 to S10) of a multi-layer circuit board (20), and the respectively assigned at least one planar sensor coil (LS1, LS2) is arranged in a second circuit board layer (S1 to S10) above or below the first circuit board layer (S1 to S10);
or **in that** the planar sensor coils (LS1, LS2) and the planar supply line coils (LG1, LG2) are each arranged in different circuit board layers (S1 to S10).

4. Monitoring arrangement (10) according to Claim 1 or 3, **characterized in that** the assigned at least one planar sensor coil (LS1, LS2) covers the corresponding planar supply line coil (LG1, LG2) at least in part, preferably completely.

5. Monitoring arrangement (10) according to one of Claims 1 to 4, **characterized in that** a signal processing means (14) which processes the detected at least one measurement signal is looped in between the signal detection means (12) and the evaluation and control unit (16).

6. Monitoring arrangement (10) according to Claim 5, **characterized in that** the signal processing means (14) comprises a rectifier (14.1) and/or a filter (14.2) and/or an amplifier (14.3).

7. Method (100) for detecting feed line faults for a control device (1), in particular a method which takes place in a monitoring arrangement according to one of Claims 1 to 6, wherein, within the control device (1), a current flow in at least two conducting internal supply lines (LB1, LB2) which are redundant in relation to one another and which are each connected at one end to an external supply line (L1_GND, L2_GND) and at the other end to a common supply potential level (C_GND) is inductively detected in each case,
wherein the detected current signals are compared with one another and evaluated, wherein, as the current flow, a high-frequency dynamic current, caused by internal switching operations, through the at least two internal supply lines (LB1, LB2) in at least two planar supply line coils (LG1, LG2), which the internal supply lines (LB1, LB2) each form upstream of the electrical connection point to the common internal supply potential level (C_GND), is detected in each case by at least one planar sensor coil (LS1, LS2) which is assigned to the corresponding planar supply line coil (LG1, LG2).

8. Method (100) according to Claim 7, **characterized in that** in order to compare and to evaluate the current signals from the two detected current signals, a difference signal is formed as a measurement signal.

9. Method (100) according to Claim 8 or 7, **characterized in that** no feed line fault is detected if a current distribution in the at least two supply line coils (LG1, LG2) is identical within a predefined tolerance window, and otherwise a feed line fault is detected.

10. Method (100) according to Claim 9 or 8, **characterized in that** different accuracy classes for the detected feed line faults are predefined by different tolerance windows.

## Revendications

1. Agencement de surveillance (10) permettant d'identifier des défauts d'amenée pour un appareil de commande (1), l'agencement de surveillance présentant
• au moins deux lignes d'alimentation internes (LB1, LB2), redondantes l'une par rapport à l'autre, conductrices de courant, disposées à l'intérieur de l'appareil de commande (1), qui sont reliées électriquement à une extrémité respectivement à une ligne d'alimentation externe (L1_GND, L2_GND) et à l'autre extrémité respectivement à un niveau de potentiel d'alimentation interne commun (C_GND) de l'appareil de commande (1),
• un dispositif de détection de signal (12) qui détecte par induction une circulation de courant sur les lignes d'alimentation internes (LB1, LB2) individuelles et émet au moins un signal de mesure correspondant, et
• une unité d'évaluation et de commande (16) qui évalue ledit au moins un signal de mesure sous la forme d'un signal de différence des signaux de courant pour identifier des défauts d'amenée,
dans lequel les deux lignes d'alimentation internes (LB1, LB2) réalisent en amont du point de jonction électrique avec le niveau de potentiel d'alimentation interne commun (C_GND) de l'appareil de commande (1) respectivement une bobine de ligne d'alimentation plane (LG1, LG2) pourvue d'au moins un enroulement,
dans lequel le dispositif de détection de signal (12) présente pour chacune des bobines de ligne d'alimentation planes (LG1, LG2) au moins une bobine de capteur plane (LS1, LS2) qui est associée respectivement à l'une des bobines de ligne d'alimentation (LG1, LG2) et détecte une circulation de courant dynamique haute fréquence, provoquée par la bobine de ligne d'alimentation (LG1, LG2) correspondante par des opérations de commutation internes.

2. Agencement de surveillance (10) selon la revendication 1, **caractérisé en ce que** les au moins deux bobines de ligne d'alimentation planes (LG1, LG2) sont configurées de manière identique, les au moins deux bobines de capteur planes (LS1, LS2) étant configurées de manière identique avec un nombre d'enroulements supérieur à celui des au moins deux bobines de ligne d'alimentation (LG1, LG2).

3. Agencement de surveillance (10) selon la revendication 1 ou 2, **caractérisé en ce que** les au moins deux bobines de ligne d'alimentation planes (LG1, LG2) sont disposées respectivement dans une première couche de carte de circuits imprimés (S1 à S10) d'une carte de circuits imprimés multicouche (20), et ladite au moins une bobine de capteur plane (L1, LS2) respectivement associée est disposée dans une deuxième couche de carte de circuits imprimés (S1 à S10) au-dessus ou au-dessous de la première couche de carte de circuits imprimés (S1 à S10) ;
ou **en ce que** les bobines de capteur planes (LS1, LS2) et les bobines de ligne d'alimentation planes (LG1, LG2) sont respectivement disposées dans différentes couches de carte de circuits imprimés (S1 à S10).

4. Agencement de surveillance (10) selon la revendication 1 ou 3, **caractérisé en ce que** ladite au moins une bobine de capteur plane (LS1, LS2) recouvre la bobine de ligne d'alimentation plane (LG1, LG2) correspondante au moins par endroits, de préférence entièrement.

5. Agencement de surveillance (10) selon l'une quelconque des revendications 1 à 4, **caractérisé en ce qu'**un dispositif de traitement de signal (14), qui traite ledit au moins un signal de mesure détecté, est mis en boucle entre le dispositif de détection de signal (12) et l'unité d'évaluation et de commande (16).

6. Agencement de surveillance (10) selon la revendication 5, **caractérisé en ce que** le dispositif de traitement de signal (14) comprend un redresseur (14.1) et/ou un filtre (14.2) et/ou un amplificateur (14.3).

7. Procédé (100) permettant d'identifier des défauts d'amenée pour un appareil de commande (1), en particulier procédé exécuté dans un agencement de surveillance selon l'une quelconque des revendications 1 à 6, dans lequel respectivement une circulation de courant dans au moins deux lignes d'alimentation internes (LB1, LB2), conductrices de courant, redondantes l'une par rapport à l'autre, qui sont reliées à une extrémité respectivement à une ligne d'alimentation externe (L1_GND, L2_GND) et à l'autre extrémité à un niveau de potentiel d'alimentation commun (C_GND), est détectée par induction à l'intérieur de l'appareil de commande (1),
dans lequel les signaux de courant détectés sont comparés entre eux et évalués, dans lequel un courant dynamique haute fréquence, provoqué par des opérations de commutation internes à travers les au moins deux lignes d'alimentation internes (LB1, LB2) dans au moins deux bobines de ligne d'alimentation planes (LG1, LG2) que les lignes d'alimentation internes (LB1, LB2) réalisent respectivement en amont de la jonction électrique avec le niveau de potentiel d'alimentation interne commun (C_GND), est détecté en tant que circulation de courant respectivement par au moins une bobine de capteur plane (LS1, LS2) qui est associée à la bobine de ligne d'alimentation plane (LG1, LG2) correspondante.

8. Procédé (100) selon la revendication 7, **caractérisé en ce qu'**un signal de différence est formé à partir des deux signaux de courant détectés pour la comparaison et pour l'évaluation des signaux de courant.

9. Procédé (100) selon la revendication 8 ou 7, **caractérisé en ce qu'**aucun défaut d'amenée n'est identifié si une distribution de courant dans les au moins deux bobines de ligne d'alimentation (LG1, LG2) est identique à l'intérieur d'une fenêtre de tolérance prédéfinie, et qu'un défaut d'amenée est identifié dans le cas contraire.

10. Procédé (100) selon la revendication 9 ou 8, **caractérisé en ce que** différentes classes de précision pour les défauts d'amenée identifiés sont prédéfinies par différentes fenêtres de tolérance.
